# EUROPEAN PATENT SPECIFICATION

(11) **EP 3 047 289 B1**
(45) Date of publication and mention of the grant of the patent: **18.12.2019**
(21) Application number: 14780516.2
(22) Date of filing: 03.10.2014
(51) Int. Cl.: G01R 31/3177, G06F 9/30, G01R 31/3185, G01R 31/317

(54) **FLEXIBLE INTERFACE**
FLEXIBLE SCHNITTSTELLE
INTERFACE FLEXIBLE

(30) Priority: 03.10.2013 GB 201317512
(43) Date of publication of application: 27.07.2016
(73) Proprietor: STMicroelectronics (Research & Development) Limited, Buckinghamshire SL7 1EY (GB)
(72) Inventor: NAPOLITANO, Leonardo, Bristol BS20 7NF (GB); FIRTH, Stephen, Chepstow NP16 7LR (GB)
(74) Representative: Smith, Gary John
(86) International application number: PCT/EP2014/071246
(87) International publication number: WO 2015/049374

(56) References cited:
- US-A1- 2003 046 622
- US-A1- 2006 156 113
- US-B2- 7 627 794
- WHETSEL L ED - INSTITUTE OF ELECTRICAL AND ELECTRONICS ENGINEERS: "ADDRESSABLE TEST PORTS AN APPROACH TO TESTING EMBEDDED CORES", PROCEEDINGS INTERNATIONAL TEST CONFERENCE 1999. ITC'99. ATLANTIC CITY, NJ, SEPT. 28 - 30, 1999; [INTERNATIONAL TEST CONFERENCE], NEW YORK, NY : IEEE, US, vol. CONF. 30, 1 September 1999 (1999-09-01), pages 1055-1064, XP000928935, ISBN: 978-0-7803-5754-9

## Description

### BACKGROUND

### Technical Field

The present application relates to the testing of embedded systems, for example the testing of embedded cores in a system on a chip (SoC).

### Description of the Related Art

With the increase in size and complexity of systems on a chip (SoC) or embedded systems, design reuse has become an important consideration. In design reuse, pre-existing design functions (for example a core or so-called intellectual property (IP) block) may be reused for new chips and applications. For example, an IP block originally integrated in a first SoC may be reused in other SoC designs. Additionally, several instances of the same IP block design may be used in a SoC.

While this reduces the complexity of the design of a SoC, it can lead to difficulties when carrying out testing of a SoC. Different cores or IP blocks may be designed and provided by different vendors, and the inner workings of the IP block may not be known by an SoC designer. Additionally, the different IP blocks may have different testing requirements and mechanisms.

In order to overcome this, testing standards have been introduced to provide a testing interface to a SoC and to IP blocks within the SoC. Examples of such testing standards may be the IEEE 1149.1 standard (JTAG) and the IEEE 1500 Standard for Embedded Core Test (SECT).

The IEEE 1149.1 standard may govern the communications between an off-chip tester and an on-chip test controller whereas the IEEE 1500 standard may govern the interface between the on-chip test access port or test mode controller and test interfaces of each IP block.

Whetsel Lee: "Addressable test ports an approach to testing embedded cores", Proceedings international test conference 1999. ITC'99. Atlantic City, NJ, Sept. 28-30, 1999; New York, NY:IEEE, US, vol. conf. 30, 1 September 1999, pages 1055-1064, ISBN: 978-0-7803-5754-9 discloses an approach to improving testing of cores embedded with system intellectual property cores by providing an addressable test port on each core. The addressable test ports provide the capability of directly addressing a core to be tested and, once addressed, testing the addressed core.

US2003046622 discloses an integrated circuit including functional input and output signal leads, input and output circuits connected to the functional input and output signal leads, core circuitry and interconnect wires and circuits connecting the input and output circuits and the core circuitry.

### BRIEF SUMMARY

According to a first aspect, there is provided a system comprising: a plurality of cores provided on one or more companion chips, each core comprising: an address line, core circuitry; and a test interface to carry out tests in relation with the core circuitry; the test interface comprising: an address register configured to hold an address of the core; and address determination circuitry configured to: compare an address received on an address line to the address held in the address register; determine based on the comparison whether the core is being addressed and to direct the test interface to carry out a testing operation in response to the determination; wherein the interface is configured by selecting one or more of a plurality of registers to be coupled between a serial test data input and a serial test data output, wherein test data input is a serial test data input and the test data output is a serial test data output.

The address line may be a parallel input. Each core may be a block of circuitry for carrying out at least one function of the system.

One of the plurality of registers may be a bypass register. When it is determined that the address received on the address line does not match the address held in the address register the bypass register may be coupled between the test data input and the test data output.

One of the plurality of registers may be a local test control register. When it is determined that the address received on the address line matches the address held in the address register the local test control register may be coupled between the test data input and the test data output.

The interface may further comprise a decoder and a control line, wherein the decoder is configured to decode an instruction on the control line and configure the local test control register in accordance with the instruction.

When a decoder of a first core determines that an instruction on the control line is invalid and address determination circuitry of the first core determines that the first core is being addressed then the local test control register of the first core may be coupled between the respective test data input and test data output. When a decoder of a first core determines that an instruction on the control line is valid and address determination circuitry of the first core determines that the first core is being addressed then the instruction may be decoded and the local test control register may be loaded in dependence on the instruction.

According to a second aspect, there may be provided a method for carrying out tests in a system comprising a plurality of cores provided on one or more companion chips, the method comprising: comparing an address received on an address line to an address held in an address register of a test interface of the core; based on the comparison, determining whether a core of the plurality of cores is being addressed; configuring the test interface to carry out a testing operation in relation to core circuitry of the core in response to the determination; and selecting one or more of a plurality of registers to be coupled between a serial test data input and a serial test data output.

The method may further comprise: determining that the address received on the address line does not match the address held in the address register; and coupling a bypass register between the test data input and the test data output in response thereto. The method may further comprise: determining that the address received on the address line matches the address held in the address register; and coupling a local test control register between the test data input and the test data output in response thereto.

The method may further comprise: decoding an instruction on a control line; and configuring the local test control register in accordance with the instruction.

The method may further comprise: determining that an instruction on a control line of a first core is invalid; determining that the first core is being addressed; and coupling a local test control register of the first core between the respective test data input and test data output in response to the determinations.

The method may further comprise: determining that an instruction on a control line of a first core is valid; determining that the first core is being addressed; decoding the instruction in response to the determinations; and loading the local test control register in dependence on the instruction.

### BRIEF DESCRIPTION OF THE SEVERAL VIEWS OF THE DRAWINGS

Non-limiting and non-exhaustive embodiments are described with reference to the following drawings, wherein like labels refer to like parts throughout the various views unless otherwise specified. Embodiments will now be described with reference to the following figures, in which:
Figure 1 shows a diagrammatic example of an SoC with testing capabilities;
Figure 2 shows a diagrammatic example of on-chip testing according to an embodiment; and
Figure 3 shows an example of a test interface.

### DETAILED DESCRIPTION

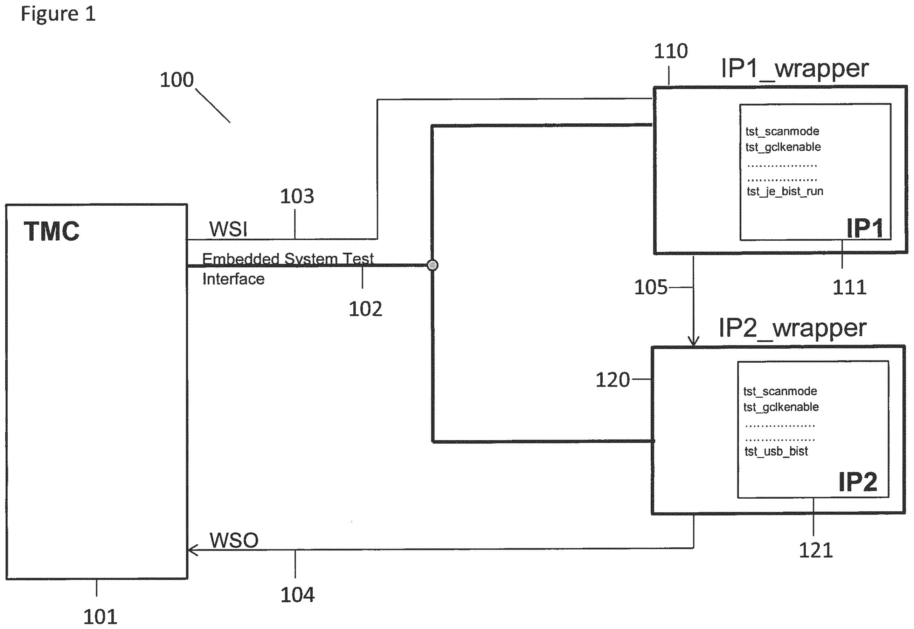

Figure 1 shows an example of a system-on-a-chip (SoC) 100 having testing capabilities. The SoC 100 of Figure 1 comprises a test mode controller (TMC) 101, a first so called "IP" block 111 and first IP block wrapper 110, and a second so called "IP" block 121 and a second IP block wrapper 120. The TMC 101 is coupled to the first and second IP block wrappers 110 and 120 via an embedded systems test interface 102. Additionally the TMC 101 is coupled to the first IP block wrapper 110 by a Wrapper Serial Input (WSI) 103 and to the second IP block wrapper 120 via a wrapper serial output (WSO) 104. A serial output of the first IP block wrapper 110 is coupled to a serial input of the second IP block wrapper 120 at 105. It will be appreciated that in some embodiments, the WSI 103 and the WSO 104 may form part of the embedded system test interface.

In some examples, the TMC 101 may act as an interface to an off-chip test controller and may control the execution of tests on the SoC 100 in accordance with an embedded systems test standard. It will be appreciated that while the TMC 101 has been described as on-chip, it may form part of the system on a chip. The TMC 101 may for example be on a companion chip to the IP blocks 111 and 121. The companion chip may be part of the same SoC as the chip carrying the IP blocks.

The TMC 101 may configure the IP blocks 111 and 121 to be tested and control testing operations of the IP blocks via the embedded systems test interface 102. Each IP block 111 and 121 may include the IP block wrapper 110 and 120 which provides a testing interface between the TMC 101 and the IP block itself.

The TMC 101 may further provide data to be shifted into registers of the IP blocks via WSI 103 and receive data shifted out from the IP blocks via WSO 104. For example, the IP blocks 111 and 121 may be configured via the embedded system interface to form a scan chain and data on the WSI 103 may be shifted through the chain sequentially through the first IP block 111 via the coupling 105 through the second IP block 121 and back to the TMC 101 via the WSO 104.

IP blocks in a SoC may be provided by different vendors and may for example correspond to the vendor's own proprietary design. These IP blocks may have individual testing requirements. In order to allow the IP blocks to be tested, each IP block is provided with a wrapper that allows testing to be carried out in accordance with a standard or agreed protocol. For example, in some embodiments, testing may be carried out in accordance with the IEEE 1500 standard.

It should be appreciated that an "IP" block may not necessarily have any intellectual property associated with it.

For example, the first IP block wrapper 110 may receive standardized testing control signals via the embedded systems test interface 102 and interface them to the IP block's 111 test signals. For example, the first IP block wrapper 110 may receive test control signals from the embedded systems test interface 102 and provide test control signals to the first IP block 111 in accordance with that block's proprietary test control requirements. The second IP block wrapper 120 may function similarly.

The IP block wrappers 110 and 120 may include for example functional inputs and outputs to and from the TMC 101 and other IP blocks as well as wrapper boundary registers, bypass register and a wrapper instruction register.

An example of the embedded systems interface at each IP block may be in accordance with the IEEE 1500 standard and include for example, a wrapper instruction register, a wrapper bypass register and a wrapper boundary register. The signals received over the interface 102 may for example include a capture, shift, update, clock, reset and the WSI 103 and WSO signals.

It will be appreciated that while the SoC 100 has been depicted as comprising two IP blocks, typically more IP blocks would be implemented in a practical system.

Data loaded into the registers of the first and second IP blocks may be loaded in sequentially through the blocks in a so-called 'daisy-chained' formation. This leads to the requirement of very large test control registers. Tests in systems with hundreds of IP blocks become very complex and time consuming to set up. Testing capabilities may not be very flexible in such systems.

Embodiments may relate to providing an interface between a test mode controller and IP block which allows a high level of flexibility. For example, some embodiments may provide an interface with a higher level of flexibility than the existing IEEE 1500 standard while still remaining compatible with that standard.

In embodiments the test mode controller and IP blocks may form part of a system on a chip. Some embodiments may provide an address connection and a control connection between the test mode controller and local IP block wrappers in addition to an embedded system test interface. The embedded system test interface may be for example in accordance with the IEEE 1500 standard.

A signal on one or both of the address and control connections may set a mode of operation of an IP block. The test interface may include a decoder for decoding control information on the control connection and an address register for determining whether that IP block is being addressed.

The control and address information received at the test interface may determine whether the IP block is to operate in accordance with the embedded system test standard or operate in accordance with a further mode of operation.

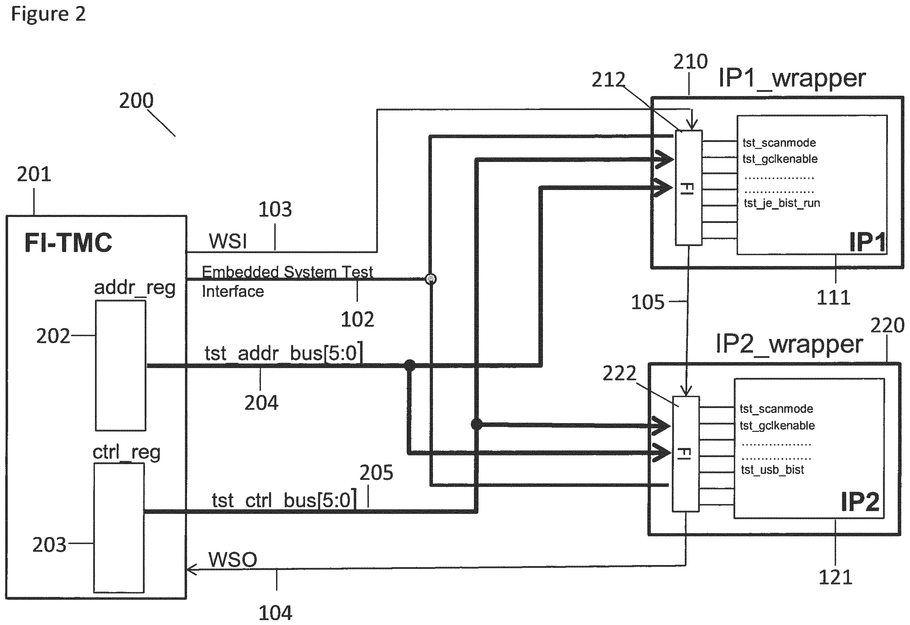

Figure 2 shows an example of a SoC 200 in accordance with an embodiment of the present application.

The SoC 200 of Figure 2 comprises a flexible interface (FI) test mode controller (TMC) 201, a first IP block 111, a first IP block wrapper 210, a second IP block 121 and a second IP block wrapper 220. The FI TMC 201 is coupled to the first and second IP block wrappers 210 and 220 via an embedded system test interface 102, to the first IP block wrapper 210 via a wrapper serial input (WSI) 103, and to the second IP block wrapper 220 via a wrapper serial output (WSO) 104. A serial output of the first IP block wrapper 210 is coupled to a serial input to the second IP block wrapper 220 at 105.

It will be appreciated that some components of the SoC 200 may be similar to those of the SoC 100 and that like reference numerals depict these.

The FI TMC 201 further includes a test address register 202 and a test control register 203. The first IP wrapper 210 further includes a wrapper flexible interface 212 and the second IP wrapper 220 further includes a wrapper flexible interface 222. The test address register 202 may be coupled to the wrapper flexible interfaces 212 and 222 via a test address bus 204. The test control register may be coupled to the wrapper flexible interfaces 212 and 222 via a test control bus 205.

It can be seen from Figure 2, that the flexible interface test mode controller 201 of some embodiments may include, in addition to standardized test interface circuitry, an address register 202 and a control register 203. The address register may be configured to store address information relating to one or more of the IP blocks or IP block wrappers. For example, an IP block and/or wrapper may be associated with an address and the address register may contain information identifying an IP block wrapper by its associated address.

The control register may be configured to store control information associated with tests to be carried out on one or more of the IP blocks. For example the control register may store test configuration information relating to the configuration of one or more of the wrapper interfaces 212, 222 for a test. In some embodiments, the control information may be a macro-instruction,

The address and control registers may be written to by the Test Mode Controller. Data to be written to these registers may originate from an off-chip testing host. The data may be provided to the TMC 101 via a testing interface, for example a JTAG Interface.

Information on the address and control buses provided to the flexible interfaces 212 and 222 of the IP blocks may be configured to determine a mode of operation of one or more of the IP blocks. For example an interface 212, 222 may determine whether the respective IP block is being addressed by information on the address bus. Additionally or alternatively, the interface 212, 222 may decode a control instruction received on the control bus 205. The information on the control and/or address buses may configure the flexible interface for a testing operation.

For example, a flexible interface may configure a local test control register of the interface based on a control instruction received over the control bus. In another example, the control information and address information may indicate to the flexible interface whether testing is to be carried out in accordance with the embedded system interface 102 signals or whether further functionality indicated by the control bus is required.

It will be appreciated that a flexible interface may be configured for various test modes or conditions in response to the information received on the control and address buses. Further such examples are discussed later.

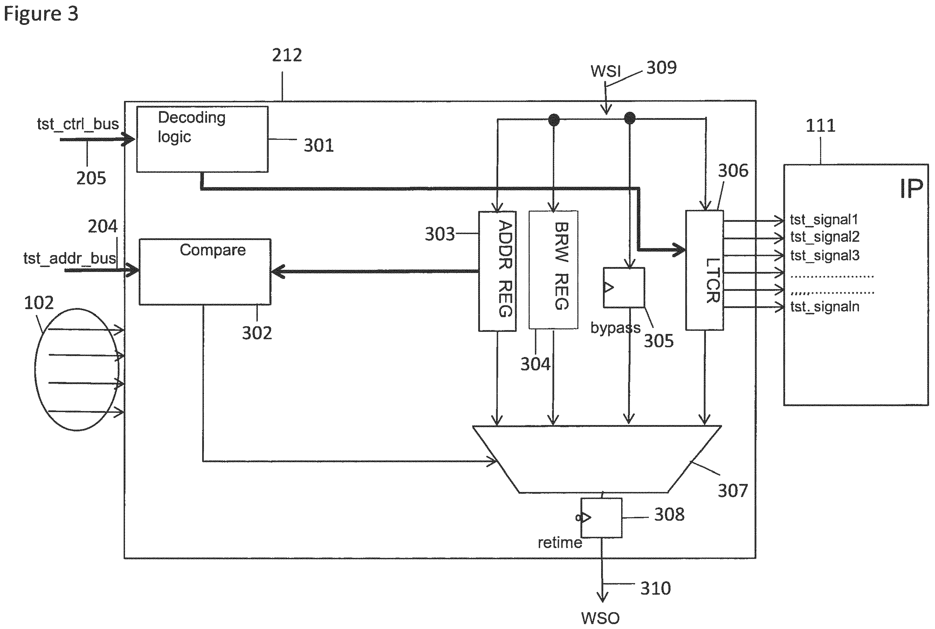

Figure 3 shows an example of a wrapper flexible interface and IP block according to an embodiment. Figure 3 may for example correspond to the interfaces 212 and/or 222 of Figure 2.

Figure 3 comprises a wrapper flexible interface 212 and IP block 111. The wrapper flexible interface may be a decoder 212. The decoder 212 may be coupled to a test control bus 205, a test address bus 204, an embedded system test interface 102, a wrapper serial input (WSI) 309 and a wrapper serial output (WSO) 310. It will be appreciated that the test control bus 205, test address bus 204 and embedded system interface 102 may correspond to the like referenced features of Figure 2 in some embodiments.

In some embodiments, the WSI 309 may be received from a flexible interface TMC, for example TMC 201 of Figure 2. In other or further embodiments the WSI 309 may be received from another wrapper flexible interface, for example as shown by coupling 105 in Figure 2.

In the example of Figure 3, the embedded system test interface 102 corresponds to an IEEE 1500 standard interface, however it will be appreciated that in other embodiments and examples, this interface 102 may differ.

The embedded system test interface 102 may comprise a plurality of signals, for example a wrapper reset signal (WRSTN), a wrapper capture signal (updateWR), a wrapper shift signal (shiftWR) and a wrapper clock (WRCK). It will be appreciated that the interface 102 may comprise signals and terminals as defined in the relevant standard. The functionality of these signals/terminals is defined in the respective standard.

The decoder 212 may be operable to decode address information carried on the address bus 204 and test control information carried on the control bus 205 in order to provide test signals in conformance with the requirements of the IP block 111. The decoder may configure the test signals passed to the IP block 111 itself in accordance with the information received on the address and/or control buses. In this manner the decoder may configure a testing operation of the IP block.

The decoder may receive test signals via one or more of the embedded systems interface 102, the test control bus 205 and the test address bus 204 and convert any test instructions received there through to test settings for the IP block 111. For example, the decoder 212 may convert a received design for test (DFT) macro instruction to the relevant ones of input test signals to the IP block 111. In the example of Figure 3, the IP block 111 may require one or more of signals tst_signal 1 to n 312 from the decoder in order to carry out a test.

It will be appreciated that the specific test signals required by an IP block may be defined by a vendor of the IP block. For example, the test signal inputs at the IP block 111 may be a test scan mode signal (tst_scanmode), a test clock enable signal (tst_gclkenable) and/or an activate a built-in-self-test signal (tst_ie/usb_bist_run) among others. These signals are shown for example in Figure 2.

In the example of Figure 3, the decoder 212 additionally is coupled to standardized test signals from the TMC. The decoder 212 may therefore be compatible with existing test interface standards governing the communication of on-chip test signals. For example, while the standardized test signals may provide information for a test, the decoder may be configured to load this information into the relevant test registers in accordance with the address and control information received at the decoder.

The relevant test registers may be part of a local test control register 306 which provides the test control registers when carrying out a test on the IP block 111.

The decoder 212 comprises a decoding logic 301, compare logic 302, address register 303, an optional spare register 304 (also called a brick wall register), a local test control register (LTCR) 306, a multiplexor 307, a bypass flip-flop 305 and a retiming flip-flop 308. The LTCR is coupled to provide the test signals to the IP block 111.

The decoding logic 301 is coupled to the test control bus 205 and an output of the decoding logic is provided as an input to the LTCR 306. The compare logic 302 is coupled to receive as inputs, the test address bus 204 and an output from the address register 303. The compare logic 302 provides a selection input to the multiplexor 307. The WSI 309 is coupled as an input to the address register 303, the spare register 304 (if present), the bypass flip-flop 305 and the LTCR 306.

Outputs from the address register 303, the spare register 304 (if present), the bypass flip-flop 305 and the LTCR 306 are coupled as inputs to the multiplexor 307. An output of the multiplexor 307 is coupled to the retiming flip-flop 308. An output of the retiming flip-flop 308 provides the WSO 310.

In operation the decoder 212 receives signals on the address bus 204, the control bus 205 and the embedded systems interface 102.

The signal on the address bus indicates whether or not that specific decoder is being addressed. An address of the decoder 212 may be stored in the address register 303. The address register may be pre-loaded with an address or an address may be written to the address register when the control bus indicates that the operation to be carried out is a write to the address register. The address in the address register may correspond to an address assigned to that register by a tester.

The compare logic 302 compares the address received on the address bus 204 to the address held in the address register 303 to determine whether the IP block 212 is being addressed. It will be appreciated that the address held in the address register 303 may not be unique to the IP block 212. For example one or more IP blocks may share an address. This may be the case where IP blocks having the same function are to be tested together.

It will also be appreciated that the address bus may address two or more blocks having different addresses. The address bus may address all blocks sharing partially the same bits in their address. For example, decoders with the same higher order bits of their addresses may be addressed.

The output of the comparator 302 determines what is connected between the wrapper serial input 309 and wrapper serial output 310. In this manner, the output of the comparator determines whether the data on the wrapper serial input 309 is to be used in testing the IP block 212.

It will be appreciated that while compare logic 302, address register 303, and multiplexor 307 are depicted, other means may be implemented to determine whether the IP block 212 is being addressed and select a test data output in response to that determination. For example, if it is determined that the IP block 212 is not being addressed, the WSO 310 may be coupled to the bypass register so that the test input data on WSI 309 bypasses the IP block 111. If it is determined for example that the IP block is being addressed, WSO 310 may be coupled to the local test control register 306 to output test data from the IP block 111.

The test control bus 205 indicates a configuration or type of test to be carried out on the IP block 111. Information received on the test control bus 205 is decoded by the decoding logic 301 to provide control signals to configure the local test control register (LTCR) 306 in accordance with a test to be carried out. It will be appreciated that the LTCR 306 may comprise one or more registers. The LTCR 306 may provide test signals to be input to the IP block 111 in carrying out a test.

The spare register 304 is provided as a register that may be used for additional tester defined functionality if necessary.

It will be appreciated that not all the features of the decoder 212 as depicted in Figure 3 are essential. Some testing environments may not require all the functionality of the decoder and the corresponding features may be omitted.

It will also be appreciated that the decoder 212 and/or wrapper interface may comprise additional signals such as test clocks, test resets, scan enable signals and scan in/out signals.

Examples of the test modes of operation that may be carried out in embodiments will now be described with reference to Table 1. It will be appreciated that the decoder 212 may be configured to implement one or more of these modes in dependence on information received on the test control and address bus signals. It will also be appreciated that this table is not exhaustive and further modes may be implemented.

**TABLE 1**

| Mode | Test address bus | Test control bus | Operation |
|---|---|---|---|
| Serial load all LTCR | Default Address (*e*.*g*., h'00) | Default (*e.g*., h'00) | All the LTCR connected in series, serial load data into them |
| Serial load addressed LTCR | Valid Address | Default or Non-Valid Instruction | Only addressed LTCR connected, the rest are in hypass |
| Bypass LTCR | Non-Valid Address | XX | Only addressed LTCR connected, the rest are in bypass |
| Load Address Register | Reserved Address (*e*.*g*., h'3F) | XX | All the Address Registers connected in series and serial loaded with addresses |
| Decode | Valid Address | Valid Instruction | The LTCR's of the addressed IP blocks are loaded in parallel |
| Load Spare Register | Reserved Address (*e.g*., h'3E) | XX | All the Spare Registers connected in series and serial loaded with addresses |

### Serial Load All LTCR:

In this embodiment the address bus determines the LTCR 306 register to be coupled between the WSI 309 and WSO 310 for all the IP blocks coupled to the TMC. The LTCR's of all the IP blocks may be coupled in series and may be loaded by sequentially shifting data through all the LTCRs. This mode allows use of the flexible interfaces 212 as a pure serial test control register

In order to address all the IP blocks the address bus may be set to a default address for all the IP blocks. For example the default address may correspond to 0. The comparator may determine that the IP block is being addressed by its default address and couple the LTCR accordingly. Optionally the test control bus may be set to its default value to indicate that a serial load is to take place.

In the case that the buses are not loaded, they may revert to the default address, e.g., 0.

In one example of a serial load of all LTCRs, the following steps may take place:
1. Apply reset;
2. After removing the reset, all the flexible interfaces 212 LTCRs are in series and can be loaded through the FI-TMC 201.

### Serial Load Addressed LTCR and Bypass Other LTCRs:

In this embodiment, selected LTCR's may be serially loaded while the remaining LTCR's are bypassed. The address bus determines that the LTCR of one or more IP blocks is/are to be coupled between the WSI 309 and WSO 310 while in the remaining IP blocks, a bypass register is coupled between the WSI 309 and WSO 310.

In this embodiment, an address shared between one or more IP blocks to be loaded is applied to the address bus. For each IP block, the comparator determines whether the address on the address bus matches the address in the address register 303. If it does, the LTCR of that flexible interface is coupled between the WSI 309 and WSO 310. If the address does not match, the bypass register 304 is coupled between the WSI 309 and WSO 310.

The data for the coupled LTCRs may then be serially shifted in through the WSI.

In one example, the following steps may take place:
This mode allows one to use the flexible interface as a local TCR to perform the test in a serial loading, but loading just the LTCRs of specific IP blocks. This mode may be used for example when a specific test signal configuration was not forecasted (no macro instruction exists for the configuration) and/or for debugging.
1. Apply reset;
2. After removing the reset, load the ADDR REG (see Table 1) putting a unique address onto the flexible interfaces 212 to be tested. If more than one IP need to be tested at the same time, then the same address must be loaded for those IP's FIs;
3. Set the test address bus to the address to match the wanted IP block;
4. Load serially the LTCR of the flexible interface addressed;
5. Repeat steps 3 and 4 to load other LTCR and/or to perform other tests

### Load Address Register:

In embodiments, a value on the address bus may determine a register to be coupled between the WSI 309 and WSO 310. In this example, the address bus determines that an address register is to be coupled between the WSI 309 and the WSO 310.

In this mode of operation the address registers of the wrapper flexible interfaces are coupled in series and are filled by shifting in address information via the WSI 309. The address on the address bus 204 may correspond to an address of the address register. For example in one embodiment, the address registers may be addressed by a reserved address such as h'3F. The test control bus does not need to hold a value.

The compare logic 302 may receive the reserved address of the address registers and provide an input to the multiplexor 307 to couple the address register 303 between the WSI 309 and WSO 310. Serial data corresponding to the addresses of the IP blocks or flexible interfaces may then be shifted through the address register in series to store the address of the IP block or interface in the address register 303.

It will be appreciated that the address stored in the address register of a wrapper flexible interface 212 may be assigned by a tester of the IP block. The address register may store a default address of 0. One or more of the FIs 212 may be loaded with the same address if they are to be tested together in parallel when in decode mode.

The address held in the address register 303 may be reset to 0 in response to a reset operation on the interface.

If, for example, no addresses are loaded into the address registers, a default address (for example the 0) on the address bus will address all the IP blocks of a TMC. In this case, every instruction on the control bus 205 will be passed to all the IP blocks. This is considered a broadcast mode of operation and is for example for use with tests such as ATPG based tests and MemBIST tests.

### Decode:

In this mode, a local test control register of a specific IP block may be configured by sending test instructions for configuring a LTCR in parallel. In other words, in this embodiment, data does not have to be sequentially shifted into the local test control register. In cases where two IP blocks share an address, their local test control registers may be loaded in parallel.

In this case, the address bus carries the address shared by one or more IP blocks. The address bus determined which register is coupled to the WSO 310 and in this case, the LTCR 306 of each addressed decoder 212 is coupled to the WSO 310.

The test control bus carries an instruction relating to a configuration of a test to be carried out. The decoding logic 301 may decode the instruction to determine the configuration of the LTCR 306 and loads the LTCR 306 with the relevant data.

In an example where more than one IP block shares an address, each of the addressed IP blocks receive the instruction on the test control bus and their respective decoders 31 configure their LTCR's accordingly.

In one example of the decode operation, the following steps may be carried out:
1. Apply reset;
2. After removing the reset, load the ADDR REG putting a unique address onto the IP's FSI to be tested;
3. Set the test address bus to the address to match the wanted IP/IPs;
4. Set the test control bus to a valid instruction to perform the wanted test;
5. Repeat steps 4 to perform more tests on the same IP/IPs or repeat steps 3 and 4 to perform more tests on different IPs.

An additional broadcast mode may exist in which an instruction may be sent in parallel to all the flexible interfaces 212 in a system. In this case, a default address may be used to address all the flexible interfaces, for example a 0 on the address bus. In some cases, the address may revert to 0 if it is not loaded. The default value in the address registers may revert to 0 after a reset.

The default address may be used to address all the flexible interfaces with a control instruction on the control bus.

In one example, broadcast mode may be implemented in the following steps:
1. Apply reset;
2. After removing the reset, put the instruction wanted onto the test control bus (loading the appropriate flexible interfaces LTCR register, then the test starts;
3. Repeat the step #2 for any other broadcast test to be performed.

### Load Spare Register:

This mode is similar to the load address register in that a specific register is addressed by a reserved address. In this case the address bus may carry a reserved address for a spare register and the spare register of the flexible interfaces 212 may be coupled in series.

Data may then be sequentially shifted into the registers.

It will be appreciated that in embodiments, addresses may be assigned to IP blocks and data loaded to the flexible interfaces multiple times. For example such operation may be carried out per test to be directed.

It will also be appreciated that in the foregoing on-chip and off-chip have been referred to. Chip here refers to an integrated circuit or a collection of related integrated circuits forming a system. For example a system on a chip may not be a single integrated circuit but may be made up of two or more companion chips.

## Claims

1. A system, comprising:
a plurality of cores (111, 121) provided on one or more companion chips, each core (111, 121) including:
an address line (204);
core circuitry; and
a test interface (212, 222) to carry out tests associated with the core circuitry, the test interface (212, 222) having an address register (303) configured to hold an address of the core (111, 121) and address determination circuitry, the address determination circuitry configured to:
compare an address received on the address line (204) to the address held in the address register (303);
determine based on the comparison whether the core (111, 121) is being addressed; and
direct the test interface (212, 222) to carry out a testing operation in response to the determination,
the system **characterised in that** the test interface (212, 222) is configured by selecting one or more of a plurality of registers to be coupled between a test data input (309) and a test data output (310), wherein the test data input is a serial test data input and the test data output is a serial test data output.

2. The system of claim 1, wherein the address line (204) is a parallel input.

3. The system of claim 1, wherein one of the plurality of registers is a bypass register (305).

4. The system of claim 3 wherein when it is determined that the address received on the address line (204) does not match the address held in the address register (303) the bypass register (305) is coupled between the test data input (309) and the test data output (310).

5. The system of any of claims 1 to 4 wherein one of the plurality of registers is a local test control register (306).

6. The system of claim 5 wherein when it is determined that the address received on the address line (204) matches the address held in the address register (303) the local test control register (306) is coupled between the test data input (309) and the test data output (310).

7. The system of any preceding claim wherein the test interface further comprises:
a control line (205); and
a decoder (301), the decoder (301) arranged to decode an instruction on the control line (205) and arranged to configure the local test control register (306) in accordance with the instruction.

8. The system of claim 7 wherein when a decoder (301) of a first core (111, 121) determines that an instruction on the control line (205) is invalid and address determination circuitry of the first core (111, 121) determines that the first core (111, 121) is being addressed then the local test control register (306) of the first core (111, 121) is coupled between the respective test data input (309) and test data output (310).

9. The system of claim 7 wherein when a decoder (301) of a first core (111, 121) determines that an instruction on the control line (205) is valid and address determination circuitry of the first core (111, 121) determines that the first core (111, 121) is being addressed then the instruction is decoded and the local test control register (306) is loaded in dependence on the instruction.

10. The system of any preceding claim wherein each core (111, 121) comprises a block of circuitry for carrying out at least one function of the system.

11. A method for carrying out tests in a system comprising a plurality of cores (111, 121) provided on one or more companion chips, the method comprising:
comparing an address received on an address line (204) to an address held in an address register (303) of a test interface (212, 222);
based on the comparison, determining whether a core (111, 121) of the plurality of cores (111, 121) is being addressed;
in response to the determination, configuring the test interface (212, 222) to carry out a test operation associated with core circuitry of the core (111, 121); and
**characterised in that** the method comprises selecting one or more of a plurality of registers to be coupled between a serial test data input (309) and a serial test data output (310).

12. The method of any of claim 11 further comprising:
determining that the address received on the address line (204) does not match the address held in the address register (303); and
in response to the determination, coupling a bypass register (305) between the test data input (309) and the test data output (310) in response thereto.

13. The method of any of claims 11 to 12 further comprising:
determining that the address received on the address line (204) matches the address held in the address register (303); and
in response to the determination, coupling a local test control register (306) between the test data input (309) and the test data output (310).

14. The method of claim 13, further comprising:
decoding an instruction on a control line (205); and
configuring the local test control register (306) in accordance with the instruction.

15. The method of any of claims 11 to 14 further comprising:
determining that an instruction on a control line (205) of the core (111, 121) is invalid; and
when it is determined that the core (111, 121) is being addressed, coupling a local test control register (306) of the first core (111, 121) between the test data input (309) and test data output (310).

## Patentansprüche

1. System, umfassend:
Eine Vielzahl von Kernen (111, 121), die auf einem oder mehreren "Companion"-Chips bereitgestellt sind, wobei jeder Kern (111, 121) einschließt:
Eine Adressenzeile (204);
Kernschaltung; und
eine Prüfschnittstelle (212, 222) zur Ausführung von Tests, die mit der Kernschaltung verbunden sind, wobei die Prüfschnittstelle (212, 222) ein Adressenregister (303) aufweist, das konfiguriert ist, eine Adresse des Kerns (111, 121) und Adressen-Bestimmungsschaltung zu beinhalten, wobei die Adressen-Bestimmungsschaltung konfiguriert ist, Folgendes zu tun:
Vergleichen einer auf der Adressenzeile (204) empfangenen Adresse mit der im Adressenregister (303) gehaltenen Adresse;
Bestimmen, auf Basis des Vergleichs, ob der Kern (111, 121) adressiert wird; und
Anweisen der Prüfschnittstelle (212, 222) einen Prüfvorgang als Antwort auf die Bestimmung auszuführen,
das System **dadurch gekennzeichnet ist, dass** die Prüfschnittstelle (212, 222) konfiguriert ist, durch Selektieren eines oder mehrerer Register, zwischen einem Prüfdateneingang (309) und einem Prüfdatenausgang (310) gekoppelt zu werden, wobei der Prüfdateneingang ein serieller Prüfdateneingang ist und der Prüfdatenausgang ein serieller Prüfdatenausgang ist.

2. System nach Anspruch 1, wobei die Adressenzeile (204) ein paralleler Eingang ist.

3. System nach Anspruch 1, wobei eines der Vielzahl von Registern ein Bypass-Register (305) ist.

4. System nach Anspruch 3, wobei, wenn bestimmt ist, dass die auf der Adressenzeile (204) empfangene Adresse nicht mit der im Adressen-Register (303) gehaltenen Adresse übereinstimmt, das Bypass-Register (305) zwischen den Prüfdateneingang (309) und den Prüfdatenausgang (310) gekoppelt wird.

5. System nach irgendeinem der Ansprüche 1 bis 4, wobei eines der Vielzahl von Registern ein lokales Prüfkontrollregister (306) ist.

6. System nach Anspruch 5, wobei, wenn bestimmt ist, dass die auf der Adressenzeile (204) empfangene Adresse mit der im Adressen-Register (303) gehaltenen Adresse übereinstimmt, das lokale Prüfkontrollregister (306) zwischen den Prüfdateneingang (309) und den Prüfdatenausgang (310) gekoppelt wird.

7. System nach irgendeinem vorhergehenden Anspruch, wobei die Prüfschnittstelle ferner umfasst:
Eine Kontrollzeile (205); und
einen Decoder (301), wobei der Decoder (301) eingerichtet ist, einen Befehl auf der Kontrollzeile (205) zu decodieren, und eingerichtet ist, das lokale Prüfkontrollregister (306) in Übereinstimmung mit dem Befehl zu konfigurieren.

8. System nach Anspruch 7, wobei, wenn ein Decoder (301) eines ersten Kerns (111, 121) bestimmt, dass ein Befehl auf der Kontrollzeile (205) ungültig ist und eine Adressen-Bestimmungsschaltung des ersten Kerns (111, 121) bestimmt, dass der erste Kern (111, 121) adressiert wird, das lokale Prüfkontrollregister (306) des ersten Kerns (111, 121) dann zwischen den jeweiligen Prüfdateneingang (309) und Prüfdatenausgang (310) gekoppelt wird.

9. System nach Anspruch 7, wobei, wenn ein Decoder (301) eines ersten Kerns (111, 121) bestimmt, dass ein Befehl auf der Kontrollzeile (205) gültig ist und eine Adressen-Bestimmungsschaltung des ersten Kerns (111, 121) bestimmt, dass der erste Kern (111, 121) adressiert wird, der Befehl dann decodiert wird und das lokale Prüfkontrollregister (306) in Abhängigkeit vom Befehl geladen wird.

10. System nach irgendeinem vorhergehenden Anspruch, wobei jeder Kern (111, 121) einen Schaltungsblock zur Ausführung zumindest einer Funktion des Systems umfasst.

11. Verfahren zur Ausführung von Prüfungen in einem System, das eine Vielzahl von Kernen (111, 121) umfasst, die auf einem oder mehreren "Companion"-Chips bereitgestellt sind, wobei das Verfahren umfasst:
Vergleichen einer auf der Adressenzeile (204) empfangenen Adresse mit einer Adresse, die in einem Adressenregister (303) einer Prüfschnittstelle (212, 222) gehalten ist;
auf dem Vergleich basierend, der bestimmt, ob ein Kern (111, 121) der Vielzahl von Kernen (111, 121) adressiert wird;
als Antwort auf das Bestimmen, Konfigurieren der Prüfschnittstelle (212, 222), um einen Prüfvorgang auszuführen, der mit Kernschaltung des Kerns (111, 121) verbunden ist; und
**dadurch gekennzeichnet, dass** das Verfahren das Selektieren eines oder mehrerer einer Vielzahl von Registern umfasst, die zwischen einem seriellen Prüfdateneingang (309) und einem seriellen Prüfdatenausgang (310) zu koppeln sind.

12. Verfahren nach Anspruch 11, ferner umfassend:
Bestimmen, dass die auf der Adressenzeile (204) empfangene Adresse nicht mit der im Adressenregister (303) gehaltenen Adresse übereinstimmt; und
als Antwort auf das Bestimmen, Koppeln eines Bypass-Registers (305) zwischen den Prüfdateneingang (309) und dem Prüfdatenausgang (310) als Antwort darauf.

13. Verfahren nach einem der Ansprüche 11 bis 12, ferner umfassend:
Bestimmen, dass die auf der Adressenzeile (204) empfangene Adresse mit der im Adressenregister (303) gehaltenen Adresse übereinstimmt; und
als Antwort auf das Bestimmen, Koppeln eines lokalen Prüfkontrollregisters (306) zwischen den Prüfdateneingang (309) und den Prüfdatenausgang (310).

14. Verfahren nach Anspruch 13, ferner umfassend:
Decodieren eines Befehls auf einer Kontrollzeile (205); und
Konfigurieren des lokalen Prüfkontrollregisters (306) in Übereinstimmung mit dem Befehl.

15. Verfahren nach einem der Ansprüche 11 bis 14, ferner umfassend:
Bestimmen, dass ein Befehl auf einer Kontrollzeile (205) des Kerns (111, 121) ungültig ist; und
wenn bestimmt ist, dass der Kern (111, 121) adressiert wird, Koppeln eines lokalen Prüfkontrollregisters (306) des ersten Kerns (111, 121) zwischen den Prüfdateneingang (309) und den Prüfdatenausgang (310).

## Revendications

1. Système, comportant :
une pluralité de cœurs (111, 121) mis en œuvre sur une ou plusieurs puces associées, chaque cœur (111, 121) comprenant :
une ligne d'adresse (204) ;
un circuit de cœur ; et
une interface de test (212, 222) servant à effectuer des tests associés au circuit de cœur, l'interface de test (212, 222) ayant un registre d'adresse (303) configuré pour retenir une adresse du cœur (111, 121) et un circuit de détermination d'adresse, le circuit de détermination d'adresse étant configuré pour :
comparer une adresse reçue sur la ligne d'adresse (204) par rapport à l'adresse retenue dans le registre d'adresse (303) ;
déterminer en se basant sur la comparaison si le cœur (111, 121) est adressé ; et
ordonner à l'interface de test (212, 222) d'effectuer une opération de test en réponse à la détermination,
le système étant **caractérisé en ce que** l'interface de test (212, 222) est configurée en sélectionnant un ou plusieurs parmi une pluralité de registres à des fins d'accouplement entre une entrée de données de test (309) et une sortie de données de test (310), dans lequel l'entrée de données de test est une entrée de données de test en série et la sortie de données de test est une sortie de données de test en série.

2. Système selon la revendication 1, dans lequel la ligne d'adresse (204) est une entrée parallèle.

3. Système selon la revendication 1, dans lequel l'un de la pluralité de registres est un registre de dérivation (305).

4. Système selon la revendication 3, dans lequel, quand il est déterminé que l'adresse reçue sur la ligne d'adresse (204) ne correspond pas à l'adresse retenue dans le registre d'adresse (303), le registre de dérivation (305) est accouplé entre l'entrée de données de test (309) et la sortie de données de test (310).

5. Système selon l'une quelconque des revendications 1 à 4, dans lequel l'un de la pluralité de registres est un registre de contrôle de test local (306).

6. Système selon la revendication 5, dans lequel, quand il est déterminé que l'adresse reçue sur la ligne d'adresse (204) correspond à l'adresse retenue dans le registre d'adresse (303), le registre de contrôle de test local (306) est accouplé entre l'entrée de données de test (309) et la sortie de données de test (310).

7. Système selon l'une quelconque des revendications précédentes, dans lequel l'interface de test comporte par ailleurs :
une ligne de contrôle (205) ; et
un décodeur (301), le décodeur (301) étant agencé pour décoder une instruction sur la ligne de contrôle (205) et étant agencé pour configurer le registre de contrôle de test local (306) en fonction de l'instruction.

8. Système selon la revendication 7, dans lequel, quand un décodeur (301) d'un premier cœur (111, 121) détermine qu'une instruction sur la ligne de contrôle (205) est invalide et quand un circuit de détermination d'adresse du premier cœur (111, 121) détermine que le premier cœur (111, 121) est adressé, alors le registre de contrôle de test local (306) du premier cœur (111, 121) est accouplé entre l'entrée de données de test (309) et la sortie de données de test (310) respectives.

9. Système selon la revendication 7, dans lequel, quand un décodeur (301) d'un premier cœur (111, 121) détermine qu'une instruction sur la ligne de contrôle (205) est valide et quand un circuit de détermination d'adresse du premier cœur (111, 121) détermine que le premier cœur (111, 121) est adressé, alors l'instruction est décodée et le registre de contrôle de test local (306) est chargé en fonction de l'instruction.

10. Système selon l'une quelconque des revendications précédentes, dans lequel chaque cœur (111, 121) comporte un bloc de circuit servant à effectuer au moins une fonction du système.

11. Procédé permettant d'effectuer des tests dans un système comportant une pluralité de cœurs (111, 121) mis en œuvre sur une ou plusieurs puces associées, le procédé comportant les étapes consistant à :
comparer une adresse reçue sur une ligne d'adresse (204) par rapport à une adresse retenue dans un registre d'adresse (303) d'une interface de test (212, 222) ;
en se basant sur la comparaison, déterminer si un cœur (111, 121) de la pluralité de cœurs (111, 121) est adressé ;
en réponse à la détermination, configurer l'interface de test (212, 222) pour effectuer une opération de test associée au circuit de cœur du cœur (111, 121) ; et
**caractérisé en ce que** le procédé comporte l'étape consistant à sélectionner un ou plusieurs parmi pluralité de registres à des fins d'accouplement entre une entrée de données de test en série (309) et une sortie de données de test en série (310).

12. Procédé selon la revendication 11, comportant par ailleurs les étapes consistant à :
déterminer que l'adresse reçue sur la ligne d'adresse (204) ne correspond pas à l'adresse retenue dans le registre d'adresse (303) ; et
en réponse à la détermination, accoupler un registre de dérivation (305) entre l'entrée de données de test (309) et la sortie de données de test (310) en réponse à celle-ci.

13. Procédé selon l'une quelconque des revendications 11 à 12, comportant par ailleurs les étapes consistant à :
déterminer que l'adresse reçue sur la ligne d'adresse (204) correspond à l'adresse retenue dans le registre d'adresse (303) ; et
en réponse à la détermination, accoupler un registre de contrôle de test local (306) entre l'entrée de données de test (309) et la sortie de données de test (310).

14. Procédé selon la revendication 13, comportant par ailleurs les étapes consistant à :
décoder une instruction sur une ligne de contrôle (205) ; et
configurer le registre de contrôle de test local (306) en fonction de l'instruction.

15. Procédé selon l'une quelconque des revendications 11 à 14, comportant par ailleurs les étapes consistant à :
déterminer qu'une instruction sur une ligne de contrôle (205) du cœur (111, 121) est invalide ; et
quand il est déterminé que le cœur (111, 121) est adressé, accoupler un registre de contrôle de test local (306) du premier cœur (111, 121) entre l'entrée de données de test (309) et la sortie de données de test (310).
